# FASCICULE DE BREVET EUROPEEN

(11) **EP 0 819 504 B1**
(45) Date de publication et mention de la délivrance du brevet: **02.10.2002**
(21) Numéro de dépôt: 97401675.0
(22) Date de dépôt: 11.07.1997
(51) Int. Cl.: B26D 7/01, B26D 7/26, B26F 1/02, H05K 3/00

(54) **Machine de poinçonnage de plaque de circuit imprimé**
Stanzvorrichtung zum Bohren von Leiterplatten
Apparatus for punching printed circuit boards

(30) Priorité: 15.07.1996 FR 9608804
(43) Date de publication de la demande: 21.01.1998
(73) Titulaire: Automa-Tech, 27100 Val de Reuil (FR)
(72) Inventeur: Sorel, Alain, 27180 Les Baux St Croix (FR); Charbonnier, Serge, 27120 Chambray (FR)
(74) Mandataire: Dronne, Guy

(56) Documents cités:
- EP-A- 0 236 766
- EP-A- 0 287 986
- EP-A- 0 620 108
- US-A- 4 829 375
- "gridless printed circuit board drilling machine" IBM TECHNICAL DISCLOSURE BULLETIN, vol. 31, no. 11, avril 1989, NEW YORK US, pages 242-243, XP000024657

## Description

La présente invention a pour objet une machine de poinçonnage de plaque de circuit imprimé.

Il existe de plus en plus de secteurs de l'activité économique qui utilisent dans leurs produits des circuits imprimés de plus en plus complexes. La complication de ces produits a entraîné la généralisation de circuits imprimés multicouches. Ces circuits multicouches consistent dans la réalisation d'un certain nombre de plaques de circuit imprimé élémentaires qui sont ensuite fixées entre elles avec, de plus, la réalisation de liaisons électriques entre les différentes couches, afin d'obtenir le circuit imprimé multicouche complet.

Du fait que, lors de la réalisation du circuit final, il est bien sur nécessaire d'empiler avec une grande précision les circuits imprimés élémentaires afin de réaliser le circuit final, il s'est développé le besoin de réaliser des moyens de repérage de position des circuits imprimés couches internes élémentaires. Ce repérage est réalisé le plus souvent à l'aide de trous percés dans le support isolant du circuit imprimé à des emplacements parfaitement définis par rapport à la plaque et/ou au circuit imprimé qui est réalisé sur celle-ci.

La réalisation de ces trous de positionnement peut être effectuée, soit sur le support isolant avant la réalisation des pistes conductrices, soit après cette réalisation. Le perçage des trous de positionnement risquant d'introduire une certaine pollution par la présence de poussières sur les surfaces des supports isolants qui entraîne bien sur une mauvaise qualité de la réalisation des dépôts conducteurs sur le support isolant, la tendance est à réaliser les trous de positionnement après que la réalisation des conducteurs ait été effectués sur le support isolant.

Quelle que soit celle qui est utilisée parmi les deux techniques possibles, la réalisation des trous de positionnement à l'aide de machines nécessite dans un premier temps le positionnement de la plaque par rapport au bâti de la machine puis le positionnement des outils de poinçonnage par rapport à ce bâti pour réaliser les trous à l'endroit convenable.

Les machines de poinçonnage les plus couramment rencontrées actuellement nécessitent des opérations manuelles pour le positionnement des outils de poinçonnage par rapport au circuit imprimé après le positionnement de celui-ci par rapport au bâti. Lorsque l'on doit réaliser un grand nombre d'opérations de poinçonnage avec des caractéristiques de poinçonnage différentes, un tel positionnement manuel est bien sur très onéreux.

C'est pourquoi on a proposé des machines dans lesquelles on pouvait commander par programmation le positionnement des outils de poinçonnage. Cependant, dans ces machines, les opérations qu'il y a lieu d'effectuer pour passer du poinçonnage d'un type de cartes de circuit imprimé à un autre type demeurent importantes et entraînent donc des pertes de temps élevées malgré le caractère pseudo-automatique du positionnement des poinçons. En particulier, il est important de souligner que, même si, à priori, les trous de positionnement ont toujours les mêmes dimensions, les outils de poinçonnage qui consistent essentiellement en un poinçon et en une matrice doivent être adaptés aux caractéristiques du support isolant du circuit imprimé. En particulier, les caractéristiques de la matrice et du poinçon dépendent de la nature du matériau constituant le support isolant du circuit imprimé et de l'épaisseur de ce support isolant. Il faut ajouter que ces opérations manuelles de changement du poinçon et de la matrice entraînent non seulement une perte de temps du fait de ces opérations elles-mêmes, mais que, de plus, elles nécessitent un repositionnement initial très précis des outils de poinçonnage après le changement du poinçon et de la matrice.

L'état de la technique le plus proche est réprésenté par le document US-A-4 829 375, selon le préambule de la revendication 1.

Dans ce document, il y a une pluralité de poinçons et de matrices ajustables.

Il existe donc un réel besoin de disposer d'une machine qui permette, non seulement le déplacement automatique des outils de poinçonnage mais également leur adaptation aux différents types de cartes dans des conditions qui permettent un remplacement rapide et qui, en particulier, ne nécessitent pas un repositionnement initial de ces outils.

En outre, ces machines ne permettent pas un chargement automatique des plaques de circuit imprimé à poinçonner, ce qui est très défavorable quant au rendement de la machine.

Pour atteindre ce but, selon l'invention, la machine de poinçonnage de plaque de circuit imprimé comprenant
- un bâti fixe,
- une table de positionnement en X, Y et θ de la plaque par rapport au bâti,
- des moyens de détection d'erreur de prépositionnement de la plaque,
- des moyens de commande de la table en fonction des erreurs détectées,
et une pluralité de blocs de poinçonnage, se caractérise en ce que chaque bloc de poinçonnage est mobile par rapport au bâti et comprend:
- un châssis mobile par rapport au bâti,
- des moyens de déplacement pour positionner chaque châssis par rapport au bâti en fonction d'instructions reçues,
- une matrice de poinçonnage non amovible solidaire du châssis mobile et disposée en dessous du plan correspondant à ladite plaque,
- un support d'outil de poinçonnage solidaire dudit châssis et disposé au dessus du plan de ladite plaque et positionné par rapport à la matrice, ledit support comportant des moyens pour recevoir de façon amovible un parmi plusieurs outils de poinçonnage adapté aux caractéristiques de ladite plaque et pour positionner ledit outil par rapport au support, et
- des moyens pour commander le déplacement vertical dudit outil dans ledit support pour réaliser le poinçonnage.

Selon un mode préféré de réalisation, la machine se caractérise en ce que chaque support d'outil de poinçonnage comprend une pièce inférieure solidaire du châssis percée d'un alésage vertical pour le positionnement et le guidage de l'ensemble constitué par l'outil de poinçonnage et le serre-flanc, une pièce supérieure montée pivotante par rapport à ladite pièce inférieure pour permettre la mise en place de l'outil dans l'alésage, ladite pièce supérieure comportant un vérin hydraulique apte à agir sur la tête de l'outil de poinçonnage et une ouverture pour l'alimentation du vérin en fluide sous pression et des moyens de verrouillage commandables de la pièce supérieure sur la pièce inférieure.

On comprend que, grâce aux caractéristiques de structure du support d'outil de poinçonnage, le remplacement de l'outil de poinçonnage est très aisé et n'entraîne aucune perte de référence de position du bloc de poinçonnage.

On comprend également que, grâce au fait que le vérin hydraulique qui permet de commander le mouvement de l'outil de poinçonnage est disposé directement dans ce support, cela permet d'alléger considérablement le bloc de poinçonnage et lui donne une grande autonomie par rapport à des systèmes dans lesquels les moyens de commande de l'outil de poinçonnage sont fixes et intéressent l'ensemble des poinçons.

D'autres caractéristiques et avantages de l'invention apparaîtront mieux à la lecture de la description qui suit d'un mode de réalisation de l'invention donné à titre d'exemple non limitatif. La description se réfère aux figures annexées sur lesquelles:
- la figure 1 est une vue de dessus de l'ensemble de la machine de poinçonnage;
- la figure 2 est une vue en coupe verticale de cette machine selon la ligne 2-2 de la figure 1;
- la figure 3 est une vue partielle de la machine montrant en élévation un bloc de poinçonnage; et
- la figure 4 est une en coupe verticale selon la ligne 4-4 de la figure 3.

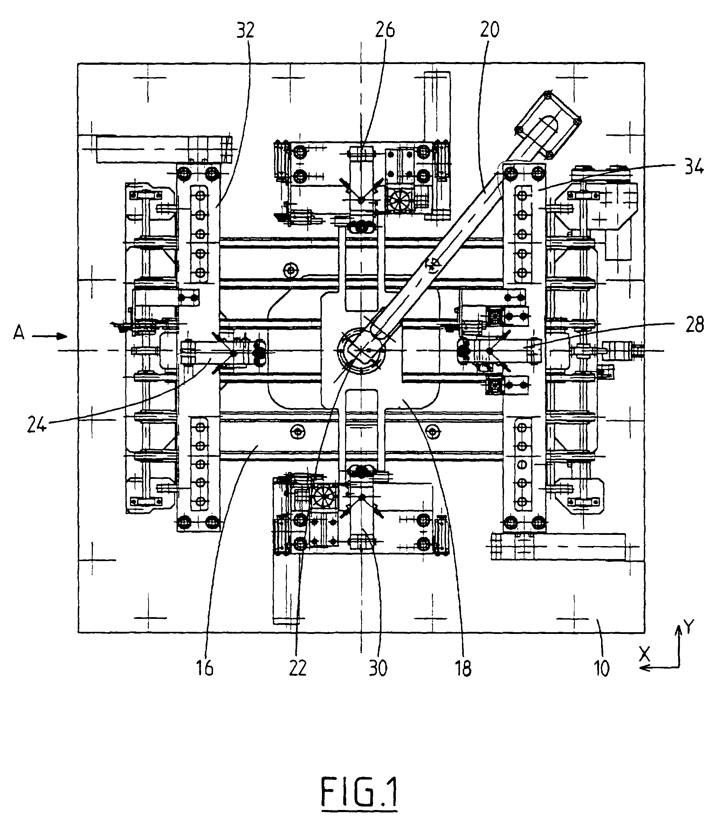

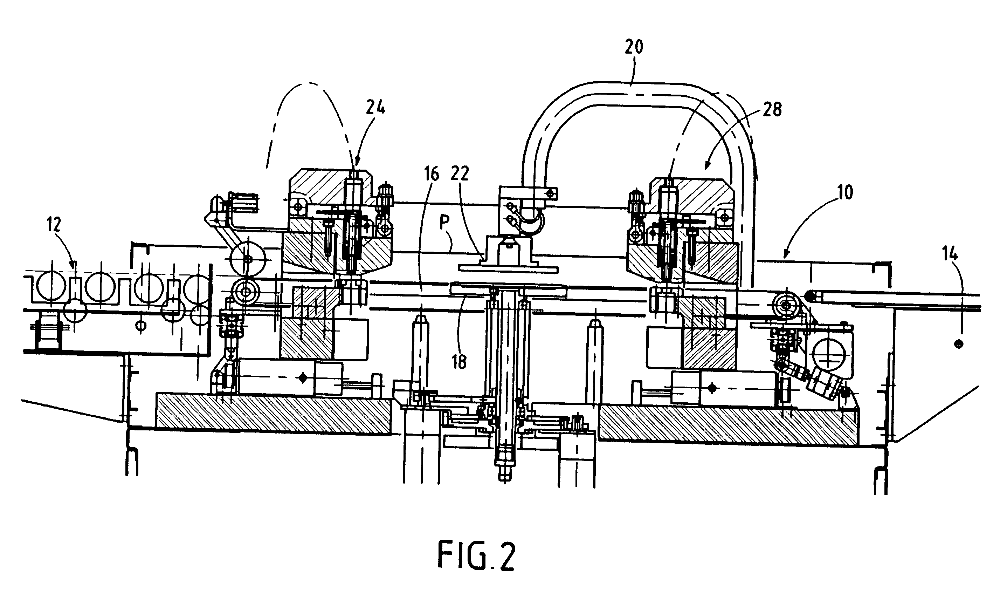

En se référant tout d'abord aux figures 1 et 2, on va décrire l'ensemble de l'organisation de la machine de poinçonnage.

La machine de poinçonnage comprend un bâti 10 et un convoyeur 12 pour amener les plaques à perforer ainsi qu'un convoyeur 14 pour évacuer les plaques après leur perforation. Un troisième convoyeur disposé dans le champ du bâti de la machine et référencé 16 sert à amener chaque plaque dans une position de prépositionnement qui est définie par des butées escamotables non représentées sur la figure.

Comme cela est bien connu, cette machine comporte des moyens de correction de l'erreur de prépositionnement. Ces moyens consistent en des détecteurs optiques qui permettent de relever l'erreur de position entre des repères prévus sur la carte de circuit imprimé et des repères fixes de la machine. Les détecteurs optiques permettent de déterminer l'erreur de position et la position correcte de la carte de circuit imprimé est obtenue à l'aide d'une table mobile 18 qui permet le déplacement de la carte selon les directions orthogonales X et Y et également d'introduire une correction en rotation. De telles tables sont en soi bien connues et il n'y a donc pas lieu de la décrire plus en détails. La liaison temporaire entre la table et la plaque lors des opérations de positionnement final est obtenue à l'aide d'un système à dépression. Selon l'invention, lorsque la plaque a été amenée dans sa position finale correcte, une pression est appliquée sur la partie centrale de cette plaque à l'aide de la potence 20 qui permet d'appliquer sur la face supérieure de la plaque l'organe de placage 22 qui sert de plus à boucher les trous qui peuvent être présents dans la carte (couches internes).

Selon l'invention, la machine de poinçonnage comporte, dans le mode de réalisation décrit ici, quatre blocs de poinçonnage référencés 24, 26, 28 et 30. Ces quatre blocs de poinçonnage sont identiques dans leur structure. Ils ne diffèrent les uns des autres que par les moyens qui permettent de les déplacer selon la direction X ou la direction Y. En particulier, comme on le voit mieux sur la figure 1, les blocs de poinçonnage 24 et 28 qui sont disposés selon la direction d'introduction A des plaques de circuit imprimé doivent bien sur autoriser le passage de ces plaques entraînées par le convoyeur 16. Pour cela, les blocs 24 et 28 sont montés sur des portiques tels que 32 et 34 qui laissent un espace libre suffisant pour le passage des plaques de circuit imprimé. En revanche, les blocs de poinçonnage 26 et 30 sont montés sur des tables en XY de type classique. Il n'est donc pas utile de décrire plus en détails les moyens de déplacement en X et en Y des blocs de poinçonnage. Il suffit d'indiquer que les mouvements en X et en Y sont commandés par des moteurs dont les circuits de commande reçoivent des instructions programmés qui permettent d'amener chaque bloc de poinçonnage dans la position en X et en Y requise correspondant aux trous à réaliser dans la plaque de circuit imprimé. On comprend donc que, déjà, la machine est d'une grande flexibilité puisque, par programmation initiale, il est possible de réaliser des trous dans une plaque à des endroits différents d'une plaque à l'autre. Cette disposition permet bien sur d'augmenter la productivité de cette machine tout en lui conservant une grande flexibilité.

Dans le cas du mode de réalisation décrit en détails, les blocs de poinçonnage 24 et 28 qui sont disposés selon la direction X, c'est-à-dire selon la direction d'introduction A des plaques de circuit imprimé sont donc montés sur les portiques 32 et 34 qui laissent le libre passage des plaques qui sont amenées en position de travail , et extraits de l'appareil par le convoyeur 16 qui s'étend sous les portiques 32 et 34. Les portiques peuvent être déplacés seulement selon la direction X.

Les blocs de poinçonnage 26 et 30 qui sont disposés selon la direction Y sont situés de part et d'autre du convoyeur 16 et ne gênent donc pas les déplacements des cartes de circuit imprimé. Dans ce mode préféré de réalisation, les blocs de poinçonnage 26 et 30 sont mobiles seulement selon la direction Y.

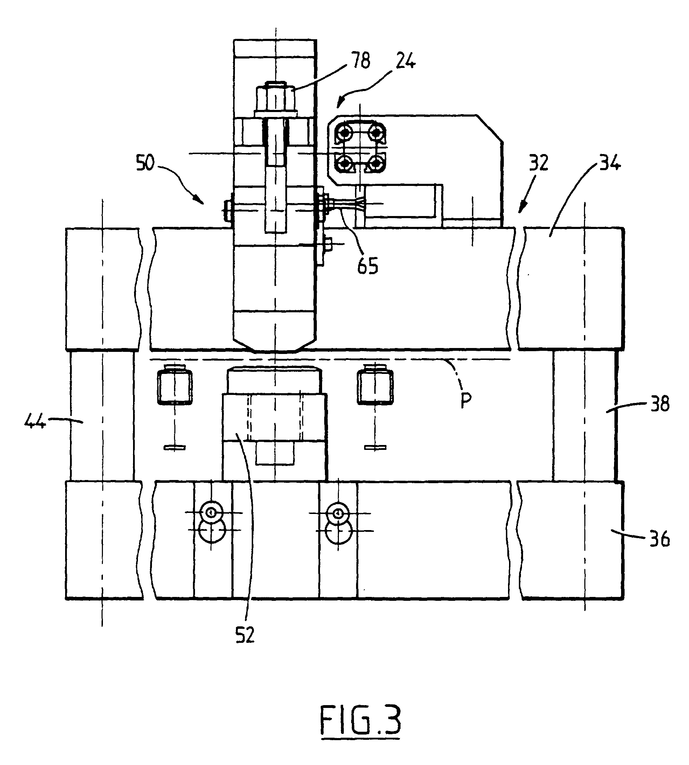

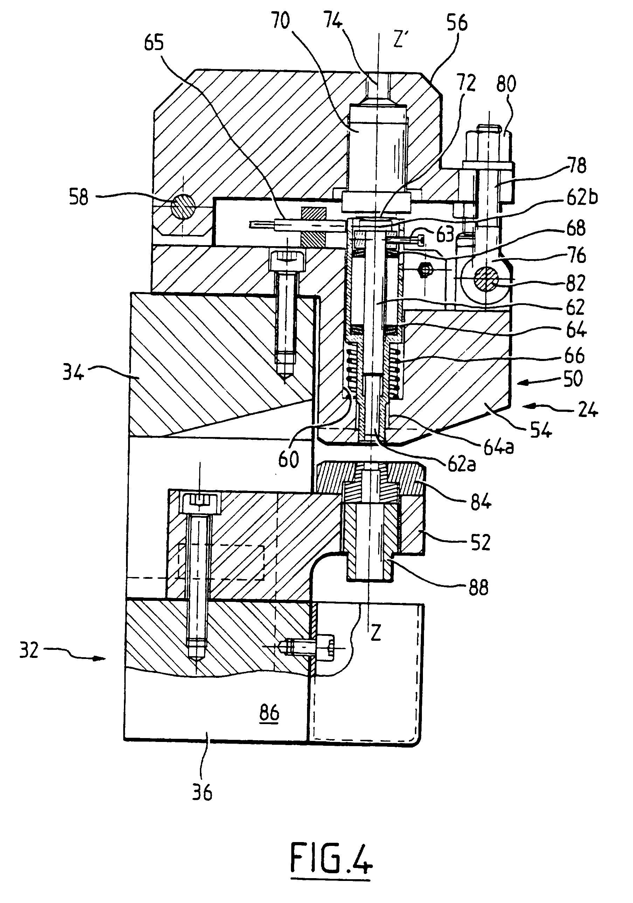

En se référant maintenant aux figures 3 et 4, on va décrire en détails un mode préféré de réalisation d'un bloc de poinçonnage, par exemple le bloc 24. Sur les figures 3 et 4, on a représenté le portique 32 sur lequel est monté le bloc de poinçonnage 24. Ce portique comporte une traverse supérieure 34 et une traverse inférieure 36 reliées entre elles par les entretoises 38 et 40 pour laisser le passage aux plaques de circuit imprimé. On a représenté en pointillés en P une telle plaque. Le bloc de poinçonnage 24 se compose essentiellement d'un support d'outils de poinçonnage 50 et d'un support de matrice 52. Ces deux supports sont respectivement solidaires des traverses supérieure et inférieure 34 et 36.

Le support d'outils 50 est essentiellement constitué par une pièce inférieure 54 solidaire de la traverse 34 et d'une pièce supérieure 56 qui est montée pivotante par rapport à la pièce 54 autour d'un axe horizontal 58. La pièce inférieure 54 comporte un alésage vertical étagé 60 servant au positionnement et au guidage de l'outil de poinçonnage 62 et de son serre-flanc cylindrique 64. le poinçon 62 comporte une extrémité inférieure coupante 62a et une tête 62b qui fait saillie au-delà de l'alésage. Le poinçon 62 est entouré par un serre-flanc 64 qui présente une extrémité active 64a entourant l'extrémité 62a du poinçon. L'ensemble constitué par le serre-flanc et le poinçon est maintenu en position relevée par le ressort de rappel 66. De même, un ressort de rappel 68 est interposé entre la tête 62b du poinçon et un épaulement du serre-flanc.

Si l'on considère maintenant la pièce supérieure 56, elle est essentiellement équipée d'un vérin hydraulique 70 dont la tige mobile 72 peut agir sur la tête 62b du poinçon lorsque la pièce 56 est dans sa position rabattue comme cela est représenté sur la figure 4. Le vérin hydraulique 70 est alimenté en liquide sous pression par une tubulure non représentée qui est raccordée au vérin 70 par l'orifice 74. Un organe de solidarisation 76 est constitué par exemple par une tige filetée 78 et un écrou 80, l'extrémité de la tige filetée étant montée pivotante autour de l'axe horizontal 82. Comme cela est bien connu, on comprend que l'on peut aisément soulever la pièce supérieure 56 en la faisant pivoter autour de l'axe 58. Dans cette position, il est aisé d'extraire le poinçon 62 pour le remplacer par un autre poinçon adapté aux caractéristiques de la plaque de circuit imprimé.

De préférence, la tête 62b est munie d'un organe spécifique 63 d'identification du type de poinçon. Un détecteur optique 65 solidaire de la pièce inférieure 54 permet de lire l'organe d'identification 63 du poinçon effectivement mis en place dans le support de poinçon. Lors de la programmation de la machine, on peut entraîner non seulement des informations relatives à la position des trous à réaliser, ainsi qu'on l'a déjà expliqué, mais également des informations relatives aux caractéristiques de la plaque de circuit imprimé à poinçonner. Comme on l'a déjà indiqué, à ces caractéristiques est associé un type spécifique de poinçon. Si le détecteur optique 65 détecte un poinçon non conforme aux caractéristiques programmées pour la plaque, le fonctionnement de la machine est interrompu.

Si l'on considère maintenant le support 52 de la matrice de poinçonnage, il comporte une bride supérieure 84 de fixation de la matrice proprement dite 86 et une pièce filetée 88 de maintien de la matrice. Bien entendu, l'axe du poinçon 62 et éventuellement le serre-flanc et l'axe de la matrice 86 sont rigoureusement confondus selon la direction verticale ZZ'. On comprend bien sur qu'il est possible de changer la matrice 86. Cependant, cette matrice est considérée comme fonctionnellement inamovible, au sens de l'invention, dans la mesure où on utilise la même matrice 86 quelles que soient les caractéristiques des plaques de circuit imprimé à poinçonner, contrairement à ce qu'on trouve dans les machines classiques de poinçonnage. C'est la combinaison particulière du poinçon et du serre-flanc qui permet d'obtenir ce résultat.

On comprend que le changement de poinçon se fait aisément en soulevant la pièce supérieure 56, ce qui ne modifie en rien la position de l'ensemble du bloc de poinçonnage.

On voit également que chaque poinçon est équipé de son propre vérin de commande, ce qui permet de simplifier considérablement l'architecture de la machine par opposition aux machines connues dans lesquelles l'ensemble des poinçons est déplacé à l'aide d'un unique système de vérin agissant simultanément sur les différents poinçons.

Il apparaît également clairement que la machine de poinçonnage est particulièrement bien adaptée à une alimentation automatique en plaque à poinçonner grâce au montage particulier des blocs de poinçonnage.

## Revendications

1. Machine de poinçonnage de plaque de circuit imprimé comprenant
- un bâti fixe (10),
- une table de positionnement (18) en X, Y et θ de la plaque par rapport au bâti,
- des moyens de détection d'erreur de prépositionnement de la plaque,
- des moyens de commande de la table en fonction des erreurs détectées,
une pluralité de blocs de poinçonnage (24,26,28,30) **caractérisé en ce que** chaque bloc de poinçonnage est mobile par rapport au bâti et comprend :
- un châssis mobile par rapport au bâti,
- des moyens de déplacement pour positionner chaque châssis par rapport au bâti en fonction d'instructions reçues,
- une matrice de poinçonnage (86) non amovible solidaire du châssis mobile et disposée en dessous du plan correspondant à ladite plaque,
- un support d'outil de poinçonnage (50) solidaire dudit châssis et disposé au dessus du plan de ladite plaque et positionné par rapport à la matrice, ledit support comportant des moyens pour recevoir de façon amovible un parmi plusieurs outils de poinçonnage (62) adapté aux caractéristiques de ladite plaque et pour positionner ledit outil par rapport au support, et
- des moyens pour commander le déplacement vertical dudit outil dans ledit support.

2. Machine selon la revendication 1, dans lequel ledit outil de poinçonnage comprend de plus un serre-flanc annulaire entourant ledit outil et en ce que ledit support est apte à recevoir et à positionner l'ensemble constitué par le serre-flanc et l'outil de poinçonnage.

3. Machine selon la revendication 1 dans lequel les moyens de déplacement de chaque bloc de poinçonnage comprennent des moyens pour définir une position de référence du bloc par rapport au bâti et des moyens pour déplacer chaque bloc de sa position de référence à la position correspondant aux instructions de positionnement reçues.

4. Machine selon la revendication 2, dans lequel chaque support d'outil de poinçonnage comprend une pièce inférieure solidaire du châssis percée d'un alésage vertical pour le positionnement et le guidage de l'ensemble constitué par l'outil de poinçonnage et le serre-flanc, une pièce supérieure amovible par rapport à ladite pièce inférieure pour permettre la mise en place de l'outil dans l'alésage, ladite pièce supérieure comportant un vérin hydraulique apte à agir sur la tête de l'outil de poinçonnage et une ouverture de l'alimentation du vérin en fluide sous pression et des moyens de verrouillage commandable de la pièce supérieure sur la pièce inférieure.

5. Machine selon la revendication 4, dans lequel ladite tête de chaque outil de poinçonnage comporte un élément d'identification de ses caractéristiques et en ce que ledit support d'outil comprend des moyens de détection de l'élément d'identification.

6. Machine selon la revendication 1, comprenant quatre blocs de poinçonnage, deux premiers blocs disposés selon la direction d'introduction des plaques de circuit imprimé, et deux autres blocs de poinçonnage disposés selon une direction orthogonale à la direction d'introduction, les deux premiers blocs étant montés sur des portiques permettant le libre passage desdites cartes.

## Claims

1. A machine for punching a printed circuit plate, the machine comprising:
· a fixed structure (10);
· an X, Y, and θ positioning table (18) for positioning the plate relative to the structure;
· means for detecting prepositioning error of the plate;
· means for controlling the table as a function of detected errors; and
a plurality of punch blocks (24, 26, 28, 30) **characterized in that** each punching block is movable relative to the structure and comprises:
· a frame that is movable relative to the structure;
· displacement means for positioning each frame relative to the structure as a function of instructions received;
. a non-removable punch die (86) secured to the moving frame and disposed beneath the plane corresponding to said plate;
· a punch tool support (50) secured to said frame and disposed above the plane of said plate and positioned relative to the die, said support including means for removably receiving one of a plurality of punch tools (62) adapted to the characteristics of said plates and for positioning said tool relative to the support; and
· means for controlling vertical displacement of said tool in said support.

2. A machine according to claim 1, in which said punch tool further includes an annular side holder surrounding said tool, and in that said support is suitable for receiving and positioning the assembly constituted by the side holder and the punch tool.

3. A machine according to claim 1, in which the means for displacing each punch block comprise means for defining a reference position of the block relative to the structure and means for displacing each block from its reference position to a position corresponding to the received positioning instructions.

4. A machine according to claim 2, in which each punch tool support comprises a bottom piece secured to the frame and pierced by a vertical bore for positioning and guiding the assembly constituted by the punch tool and the side holder, a top piece that is removable relative to said bottom piece to enable the tool to be put into place in the bore, said top piece including a hydraulic actuator suitable for acting on the head of the punch tool and an opening for feeding the actuator with fluid under pressure, and controllable locking means for locking the top piece on the bottom piece.

5. A machine according to claim 4, in which said head of each punch tool includes an identification element identifying the characteristics thereof, and in that said tool support includes means for detecting the identification element.

6. A machine according to claim 1, comprising four punch blocks, two first blocks disposed in the direction in which printed circuit plates are inserted, and two other punch blocks disposed in a direction orthogonal to the insertion direction, the first two blocks being mounted on gantries allowing said plates to pass freely.

## Patentansprüche

1. Stanzvorrichtung für Leiterplatten, umfassend:
- einen festen Rahmen (10),
- einen Positioniertisch (18) für die Leiterplatte in Richtung X, Y und Θ bezüglich des Rahmens,
- Detektormittel, um Fehler der Vorpositionierung der Leiterplatte festzustellen,
- Steuermittel für den Tisch in Abhängigkeit von den festgestellten Fehlern,
- eine Mehrzahl von Stanzblöcken (24, 26, 28, 30), **dadurch gekennzeichnet, dass** jeder Stanzblock bezüglich des Rahmens beweglich ist und umfasst:
- ein bezüglich des Rahmens mobiles Chassis,
- Verschiebemittel, um jedes Chassis bezüglich des Rahmens in Abhängigkeit von erhaltenen Instruktionen zu positionieren,
- eine Stanzmatrize (86), die unbeweglich mit dem beweglichen Chassis verbunden ist und unter der Ebene, die der Leiterplatte entspricht, liegt,
- ein Träger für die Stanzwerkzeuge (50), der mit dem Chassis verbunden ist, oberhalb der Ebene der Leiterplatte liegt und bezüglich der Matrize positioniert ist, der Träger umfasst Mittel, um auf bewegliche Weise eines von mehreren Stanzwerkzeugen (62) zu empfangen, das an die Eigenschaften der Leiterplatte angepasst ist und um das Werkzeug bezüglich des Trägers zu positionieren und
- Mittel, um die vertikale Verschiebung des Werkzeugs im Träger zu bewirken.

2. Vorrichtung nach Anspruch 1, bei der das Stanzwerkzeug eine ringförmige Klemmfläche aufweist, die das Werkzeug umgibt und bei der der Träger so ausgebildet ist, dass er das aus dem Stanzwerkzeug und der Klemmfläche bestehende Ensemble aufnehmen und positionieren kann.

3. Vorrichtung nach Anspruch 1, bei der die Verschiebemittel für jeden Stanzblock Mittel umfassen, um eine Referenzposition des Blockes bezüglich des Rahmens zu definieren und Mittel, um jeden Block von seiner Referenzposition an die Position zu bringen, die den erhaltenen Positionierungsinstruktionen entspricht.

4. Vorrichtung nach Anspruch 2, bei der jeder Träger der Stanzwerkzeuge einen unteren Teil aufweist, der mit dem Chassis durch eine vertikale Bohrung für die Positionierung verbunden ist, wobei die Führung des Ensembles, bestehend aus dem Stanzwerkzeug und der Klemmfläche, aus einem oberen Teil besteht, der bezüglich des genannten unteren Teils beweglich ist um die Plazierung des Werkzeugs in der Bohrung zu erlauben, wobei der obere Teil eine hydraulische Zylinder-Kolben-Einheit aufweist, die in der Lage ist, auf den Kopf des Stanzwerkzeuges zu wirken und wobei eine Öffnung in der Versorgung des Kolbens mit dem Druckfluid und betätigbare Verriegelungsmittel für den oberen Teil mit dem unteren Teil vorhanden sind.

5. Vorrichtung nach Anspruch 4, wobei der Kopf jedes Stanzwerkzeuges ein Identifikationselement für seine Eigenschaften aufweist und wobei der Werkzeugträger Detektormittel für das Identifikationselement aufweist.

6. Vorrichtung nach Anspruch 1, umfassend vier Stanzblöcke, zwei erste Blöcke, die in der Einbringungsrichtung der Leiterplatten angeordnet sind und zwei andere Stanzblöcke, die in einer zur Einbringungsrichtung normalen Richtung angeordnet sind, die beiden ersten Blöcke sind auf Portalen montiert, die das freie Durchlassen der Leiterplaten erlauben.
